(19) Europäisches Patentamt
European Patent Office
Office européen des brevets

(11) **EP 4 521 384 A1**

(12) **EUROPEAN PATENT APPLICATION**
published in accordance with Art. 153(4) EPC

(43) Date of publication:
**12.03.2025 Bulletin 2025/11**

(51) International Patent Classification (IPC):
**G09F 9/30** (2006.01)     **H04M 1/02** (2006.01)

(21) Application number: **23826410.5**

(22) Date of filing: **20.06.2023**

(86) International application number:
**PCT/CN2023/101342**

(87) International publication number:
**WO 2023/246763 (28.12.2023 Gazette 2023/52)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **22.06.2022 CN 202210711705**

(71) Applicant: **Huawei Technologies Co., Ltd.**
**Shenzhen, Guangdong 518129 (CN)**

(72) Inventors:
• **WANG, Chaochen**
**Shenzhen, Guangdong 518129 (CN)**
• **LI, Min**
**Shenzhen, Guangdong 518129 (CN)**

(74) Representative: **Maiwald GmbH**
**Engineering**
**Elisenhof**
**Elisenstrasse 3**
**80335 München (DE)**

(54) **SUPPORTING MEMBER, METHOD FOR PREPARING SUPPORTING MEMBER, AND DISPLAY MODULE AND ELECTRONIC DEVICE**

(57) Embodiments of this application disclose a support member, a method for manufacturing a support member, a display module, and an electronic device. The support member is configured to support a display. The display includes a first unbendable portion, a second unbendable portion, and a bendable portion. The support member includes a first support member opposite to the first unbendable portion, a second support member opposite to the second unbendable portion, and a bendable support member opposite to the bendable portion. The bendable support member is located between the first support member and the second support member. The bendable support member is provided with one or more through holes that penetrate through the bendable support member. An opening of the through hole is located on a surface of the bendable support member opposite to the bendable portion. The through hole is filled with a filling material. Therefore, anti-impact performance and anti-extrusion performance of the electronic device can be improved. An elastic modulus of the filling material is less than an elastic modulus of the support member, so that bending performance of a bendable region of the support member can be further improved.

FIG. 4

## Description

"This application claims priority to Chinese Patent Application No. 202210711705.9, filed with the China National Intellectual Property Administration on June 22, 2022 and entitled SUPPORT MEMBER, METHOD FOR MANUFACTURING SUPPORT MEMBER, DISPLAY MODULE, AND ELECTRONIC DEVICE, which is incorporated herein by reference in its entirety. "

## TECHNICAL FIELD

Embodiments of this application relate to the display field, and in particular, to a support member, a method for manufacturing a support member, a display module, and an electronic device.

## BACKGROUND

With continuous development of display technologies, an electronic device gradually becomes a development trend of a future mobile electronic product. When the electronic device is in an unfolded state, a large display area can be provided, improving video watching effect. When the electronic device is in a folded state, a small volume can be provided, bringing convenience of carrying for a user.

The electronic device includes at least a flexible display and a support member for bearing the flexible display. The flexible display includes a bendable portion, and a through hole is provided on a region that is of the support member and that corresponds to the bendable portion, to improve bending performance of the support member.

However, if the through hole is provided on the region that is of the support member and that corresponds to the bendable portion, anti-extrusion performance and anti-impact performance of a bendable portion region of the flexible display are poor, and a poor appearance phenomenon such as a crack or a crease of the bendable portion region occurs on the display, degrading user experience.

## SUMMARY

Embodiments of this application provide a support member, a method for manufacturing a support member, a display module, and an electronic device, to resolve problems of poor anti-extrusion performance and anti-impact performance of an existing electronic device.

To achieve the foregoing objective, the following technical solutions are used in embodiments of this application.

According to a first aspect of embodiments of this application, a support member is provided. The support member is configured to support a display. The display includes a first unbendable portion, a second unbendable portion, and a bendable portion. The support member includes a first support member opposite to the first unbendable portion, a second support member opposite to the second unbendable portion, and a bendable support member opposite to the bendable portion. The bendable support member is located between the first support member and the second support member. The bendable support member includes a first surface opposite to the bendable portion and a second surface opposite to the first surface. One or more through holes are provided on the bendable support member. The through hole penetrates through the first surface and the second surface of the bendable support member. The through hole is filled with a filling material. A thickness of the filling material is less than or equal to a thickness of the support member. An elastic modulus of the filling material is less than an elastic modulus of the support member. Therefore, the filling material is disposed in the through hole of the support member, to improve anti-impact performance and anti-extrusion performance of an electronic device. The elastic modulus of the filling material is less than the elastic modulus of the support member. When the filling material is compressed or stretched, deformation of the filling material is greater than deformation of the support member. The filling material is disposed in the through hole of the support member, to help further improve bending performance of a bendable region of the support member.

In an optional implementation, the filling material is filled into the through hole in an inkjet printing manner. Therefore, a filling manner of the inkjet printing can implement patterned coating, and has advantages of high printing precision and good uniformity of a printed filling material.

In an optional implementation, the filling material includes at least one of a filling adhesive, resin, and a polymer material. In this way, an optional material of the filling material is more diversified.

In an optional implementation, the filling adhesive includes at least one of a photosensitive adhesive, a thermosetting adhesive, and a moisture-curing adhesive. In this way, an optional material of the filling adhesive is more diversified.

In an optional implementation, the filling material is in a strip shape. A length direction of the filling material is parallel to a length direction of the bendable portion. Therefore, the anti-extrusion performance of the support member can be improved.

In an optional implementation, the filling material further includes a first limiting portion. The first limiting portion is disposed on at least one end of the filling material in the length direction. The first limiting portion is snap-fitted to the through hole. Therefore, the first limiting portion may change stress distribution on the support member.

In an optional implementation, the filling material further includes a second limiting portion. The second limiting portion is disposed on at least one end of the filling material in a thickness direction. The second limiting portion is snap-fitted to the through hole. In this way, the second limiting portion may prevent the filling material from being extruded out during use.

In an optional implementation, the filling material meets at least one of the following conditions: a Young's modulus is greater than 1 MPa; a glass transition temperature is less than 0°C; a stress relaxation recovery rate is greater than 90%; and an elastic limit is greater than 50%. Therefore, the filling material is disposed in the through hole of the support member, to help improve the anti-extrusion performance and the anti-impact performance of the support member.

In an optional implementation, a material of the support member includes at least one of a fiber, a pure metal, and an alloy. Therefore, the anti-extrusion performance and the anti-impact performance of the support member can be improved.

According to a second aspect of embodiments of this application, a method for manufacturing a support member is provided. The support member is configured to support a display. The display includes a first unbendable portion, a second unbendable portion, and a bendable portion. The support member includes a first support member opposite to the first unbendable portion, a second support member opposite to the second unbendable portion, and a bendable support member opposite to the bendable portion. The bendable support member is located between the first support member and the second support member. The method includes: filling a filling material into a through hole of the bendable support member in an inkjet printing manner, where the bendable support member includes a first surface opposite to the bendable portion and a second surface opposite to the first surface, one or more through holes are provided on the bendable support member, and the through hole penetrates through the first surface and the second surface of the bendable support member; and curing the filling material, where a height of the filling material is less than or equal to a height of the through hole, and an elastic modulus of the filling material is less than an elastic modulus of the support member. Therefore, a filling manner of the inkjet printing can implement patterned coating, and has advantages of high printing precision and good uniformity of a printed filling material.

In an optional implementation, the filling a filling material into a through hole of the support member in an inkjet printing manner includes: attaching a bearing layer to one surface of the support member; and performing inkjet printing on a surface that is of the support member and that is away from the bearing layer, and filling the filling material into the through hole of the support member.

It should be noted that the bearing layer may be a release film or a display.

In an optional implementation, the bearing layer is the release film. After the curing the filling material, the method further includes: removing the bearing layer.

In an optional implementation, the bearing layer is the display. After the curing the filling material, the display may not need to be removed, so that the display is connected to a support layer through the filling material.

According to a third aspect of embodiments of this application, a display module is provided, including a display and the foregoing support member. The display includes a display panel and a cover plate that are disposed in a stacked manner. A backlight surface of the display panel is close to the support member. The cover plate is disposed on a light-emitting surface of the display panel. Therefore, the display module uses the foregoing support member, so that anti-impact performance and anti-extrusion performance of the display module are improved.

In an optional implementation, a protective film is disposed on a side that is of the cover plate and that is away from the display panel. Therefore, the protective film may protect the display.

According to a fourth aspect of embodiments of this application, an electronic device is provided, including a housing and the display module described above. The housing is disposed on a side that is of the support member and that is away from the display. Therefore, the electronic device uses the foregoing display module, so that anti-impact performance and anti-extrusion performance of the electronic device are improved.

Embodiments of this application provide the support member, the method for manufacturing the support member, the display module, and the electronic device. The filling material is disposed in the through hole in the bendable region of the support member, to improve the anti-impact performance and the anti-extrusion performance of the electronic device. The elastic modulus of the filling material is less than the elastic modulus of the support member. When the filling material is compressed or stretched, the deformation of the filling material is greater than the deformation of the support member. The filling material is disposed in the through hole of the support member, to help further improve the bending performance of the bendable region of the support member.

**BRIEF DESCRIPTION OF DRAWINGS**

FIG. 1a is a diagram of a disassembling structure of an electronic device according to an embodiment of this application;

FIG. 1b is a diagram of a structure of a display module according to an embodiment of this application;

FIG. 2 is an A-A sectional view of the display module in FIG. 1b;

FIG. 3 is a diagram of a disassembling structure of a display module according to an embodiment of this application;

FIG. 4 is a diagram of a structure of a support member according to an embodiment of this application;

FIG. 5 is a flowchart of a method for manufacturing a support member according to an embodiment of this application;

FIG. 6 is a diagram of an inkjet printing window according to an embodiment of this application;

FIG. 7 is a flowchart of another method for manufacturing a support member according to an embodiment of this application;

FIG. 8, FIG. 9, FIG. 10, and FIG. 11 are respectively diagrams of structures of products after steps in FIG. 7 are performed;

FIG. 12 is a flowchart of another method for manufacturing a support member according to an embodiment of this application;

FIG. 13, FIG. 14, and FIG. 15 are respectively diagrams of structures of products after steps in FIG. 12 are performed;

FIG. 15a is a diagram of a structure of a bendable support member according to an embodiment of this application;

FIG. 15b is a top view of the bendable support member in FIG. 15a;

FIG. 16 is a B-B sectional view in FIG. 15a;

FIG. 17 is a B-B sectional view in FIG. 15a;

FIG. 18 is a B-B sectional view in FIG. 15a;

FIG. 19 is a B-B sectional view in FIG. 15a;

FIG. 20 is a B-B sectional view in FIG. 15a;

FIG. 21 is a C-C sectional view in FIG. 15a;

FIG. 22 is a C-C sectional view in FIG. 15a;

FIG. 23 is a C-C sectional view in FIG. 15a;

FIG. 24 is a C-C sectional view in FIG. 15a;

FIG. 25 is a partial enlarged view of a bendable support member;

FIG. 26 is a top view of an electronic device according to an embodiment of this application;

FIG. 27 is a diagram of an internal structure of an electronic device according to an embodiment of this application;

FIG. 28 is a diagram of an impact test result at a weak location in a rotating shaft region of an electronic device;

FIG. 29 is a diagram of an extrusion test result of an electronic device according to an embodiment of this application; and

FIG. 30 is a simulation diagram of an extrusion test result of an electronic device according to an embodiment of this application.

## DESCRIPTION OF EMBODIMENTS

To make the objectives, technical solutions, and advantages of this application clearer, the following further describes this application in detail with reference to accompanying drawings.

Terms such as "first" and "second" mentioned below are merely intended for a purpose of description, and shall not be understood as an indication or implication of relative importance or implicit indication of a quantity of indicated technical features. Therefore, a feature limited by "first", "second", and the like may explicitly or implicitly include one or more such features. In description of this application, unless otherwise specified, "a plurality of" means two or more than two.

In addition, in this application, orientation terms such as "up" and "down" are defined relative to an orientation of a schematically placed component in the accompanying drawings. It should be understood that these direction terms are relative concepts and are used for relative description and clarification, and may vary correspondingly based on a change in an orientation in which the component is placed in the accompanying drawings.

An embodiment of this application provides an electronic device. The electronic device may be a product having a display interface, such as a mobile phone, a display, a tablet computer, or an in-vehicle computer. A specific form of the electronic device is not specially limited in embodiments of this application.

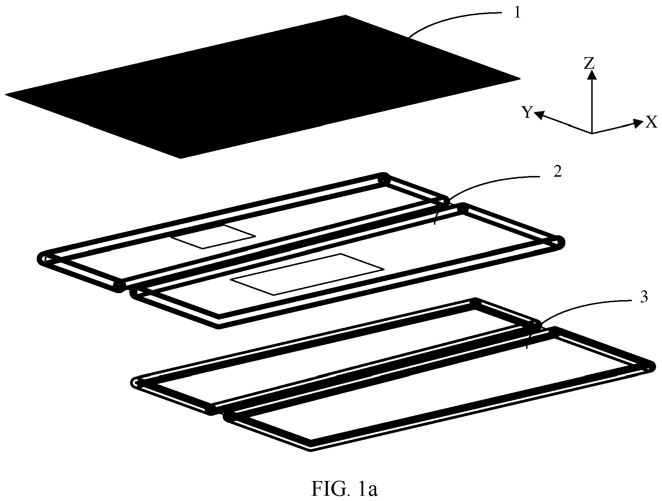

FIG. 1a is a diagram of a disassembling structure of an electronic device according to an embodiment of this application. As shown in FIG. 1a, the electronic device includes a display module 1, a middle frame 2, and a housing 3 (or referred to as a battery cover or a rear housing). The middle frame 2 is located between the display module 1 and the housing 3.

The display module 1 is configured to display an image.

A surface that is of the middle frame 2 and that is away from the display module 1 is configured to install an internal element such as a battery, a printed circuit board (printed circuit board, PCB), a camera (camera), or an antenna. After the housing 3 and the middle frame 2 are covered, the foregoing internal element is located between the housing 3 and the middle frame 2, so that external vapor and dust can be prevented from intruding into an accommodate cavity and affecting performance of the foregoing electronic component.

The display module 1 may be electrically connected, through a flexible printed circuit (flexible printed circuit, FPC), to the PCB disposed on the middle frame 2. Therefore, the PCB can transmit display data to the display module 1, to control the display module 1 to display the image.

The display module 1, the middle frame 2, and the housing 3 may be respectively disposed at different layers in a thickness direction of the electronic device. These layers may be parallel to each other. A plane in which each layer is located may be referred to as an X-Y plane, and a direction perpendicular to the X-Y plane may be referred to as a Z direction. In other words, the display module 1, the middle frame 2, and the housing 3 may be distributed hierarchically in the Z direction.

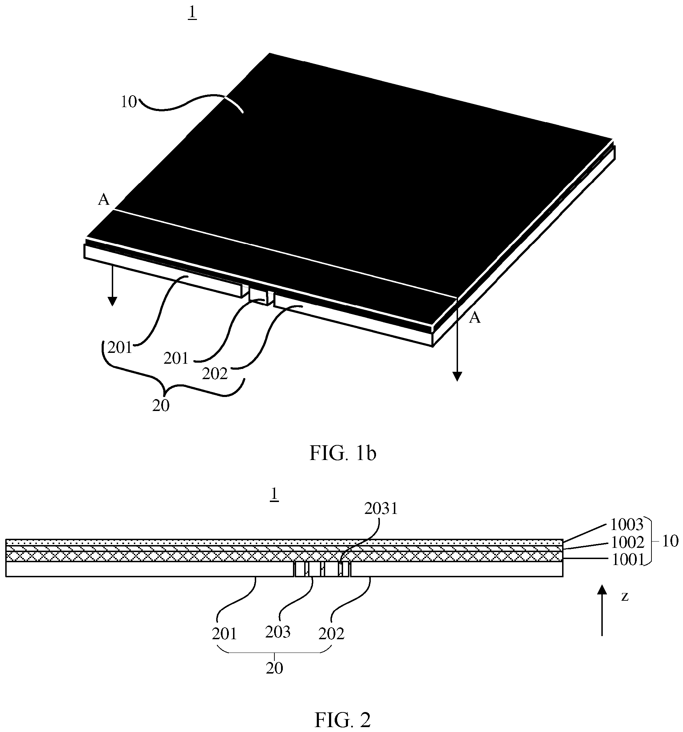

FIG. 1b is a diagram of a structure of a display module according to an embodiment of this application. As shown in FIG. 1b, the display module includes a display 10 and a support member 20 configured to support the display 10.

A structure of the display 10 is not limited in this embodiment of this application. In some embodiments, as shown in FIG. 2, the display 10 includes a protective film 1003, a cover plate 1002, and a display panel 1001 that are disposed in a stacked manner in a Z direction. The support member 20 is disposed on a side that is of the display panel 1001 and that is away from the cover plate 1002. The support member 20 may support the display 10 and dissipate heat for the display 10.

A structure of the display panel 1001 is not limited in this application. For example, the display panel 1001 is an active matrix organic light emitting diode (active matrix organic light emitting diode, AMOLED) display.

Because the AMOLED display is a self-luminous display, a back light module (back light module, BLM) is not required to be disposed in the AMOLED display. Therefore, when a substrate in the AMOLED display is made of a flexible resin material, for example, polyethylene terephthalate (polyethylene terephthalate, PET), the foregoing AMOLED display can have a bendable feature.

The cover plate 1002 and the protective film 1003 may protect the display panel 1001, to avoid interference caused by an external environment to the display panel 1001.

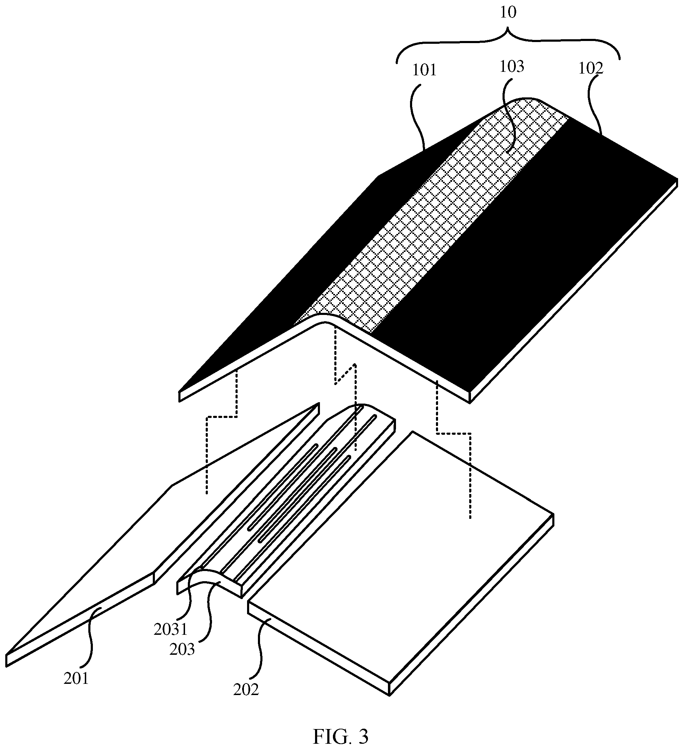

FIG. 2 is an A-A sectional view of FIG. 1b. FIG. 3 is a diagram of a disassembling structure of a display module according to an embodiment of this application.

As shown in FIG. 2 and FIG. 3, the support member 20 includes at least a first support member 201, a second support member 202, and a bendable support member 203.

As shown in FIG. 3, the display 10 is, for example, a flexible display. The display 10 includes: a first unbendable portion 101, a second unbendable portion 102, and a bendable portion 103. The bendable portion 103 is located between the first unbendable portion 101 and the second unbendable portion 102.

The first support member 201 is connected to the first unbendable portion 101 of the display 10. The second support member 202 is connected to the second unbendable portion 102 of the display 10. The bendable support member 203 is connected to the bendable portion 103 of the display 10.

When an included angle $\alpha$ between the first support member 201 and the second support member 202 is less than 180°, the display 10 is in a bent state.

Alternatively, when an included angle $\alpha$ between the first support member 201 and the second support member 202 increases to 180°, the display 10 is in an unfolded state.

The foregoing first support member 201 and the second support member 202 are configured to support the display 10 in a process of unfolding and folding the display 10, to ensure flatness of the display 10, and protect a non-display surface of the display 10.

The foregoing bendable support member 203 is opposite to the bendable portion 103 of the display 10. When the display 10 is bent or unfolded, the bendable support member 203 can be bent or unfolded accordingly.

To improve bending performance of the bendable support member 203, in some embodiments, as shown in FIG. 2 and FIG. 3, one or more through holes 2031 are provided on the bendable support member 203. The through hole 2031 penetrates through the bendable support member 203 in a thickness direction of the bendable support member 203.

An opening of the through hole is located on a surface that is of the bendable support member and that is opposite to the bendable portion.

In some embodiments, an extension direction of the through hole 2031 is perpendicular to a plane of the support member 20.

However, an impact reliability test is performed on an electronic device, and it is found that the through hole is provided on a region that is of the support member and that corresponds to the bendable portion, consequently, anti-extrusion performance and anti-impact performance of a bendable portion region of the flexible display are poor, and a poor appearance phenomenon such as an orange peel texture, a mold print, or a crease of the bendable portion region occurs on the display, degrading user experience.

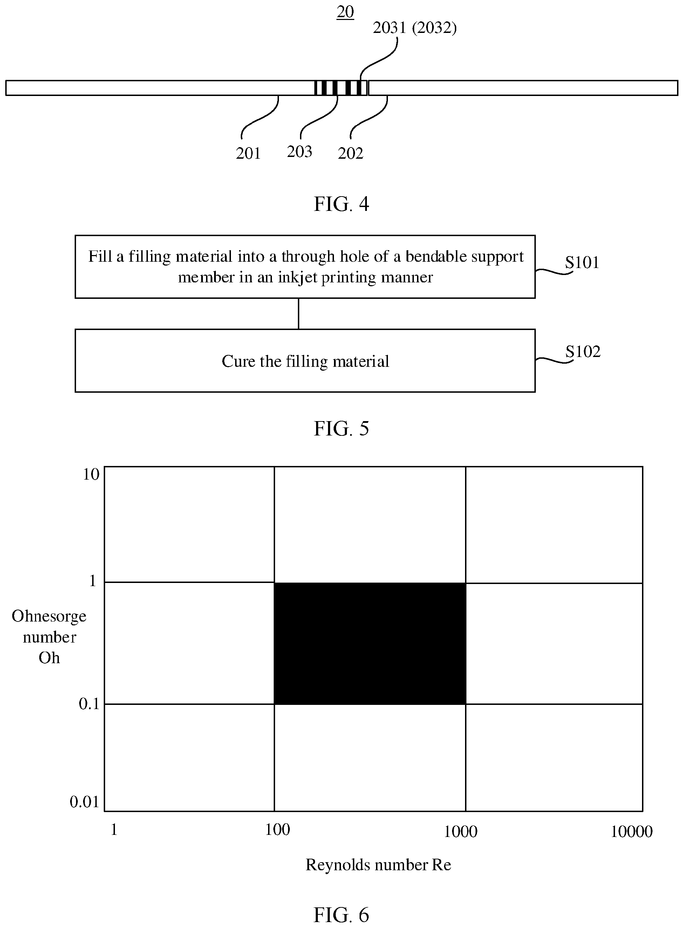

Therefore, embodiments of this application provide an improved support member. FIG. 4 is a diagram of a structure of a support member according to an embodiment of this application. As shown in FIG. 4, a support member 20 includes: a first support member 201, a second support member 202, a bendable support member 203, and a filling material 2032. The filling material 2032 is filled into a through hole 2031 of the bendable support member 203.

The first support member 201 is configured to support a first unbendable portion of a display. The second support member 202 is configured to support a second unbendable portion of the display. The bendable support member is configured to support a bendable portion of the display. The bendable support member 203 is located between the first support member 201 and the second support member 202.

A structure of the filling material 2032 is not limited in this embodiment of this application. The filling material 2032 should meet that an elastic modulus of the filling material 2032 is less than an elastic modulus of the support member 20. For example, the elastic modulus of the filling material 2032 is greater than 1 MPa.

It should be noted that, the elastic modulus is a physical quantity that describes a deformation resistance capability of a solid material.

For example, the elastic modulus in this application may be a Young's modulus.

A definition of the Young's modulus is explained and described below.

A Young's modulus of the filling material 2032 may be represented by a Young's modulus E.

The Young's modulus E satisfies: $E = \sigma/\varepsilon$. $\sigma$ represents stress, and means a force applied to a unit cross-sectional area of the filling material 2032. $\varepsilon$ represents strain, and means an elongation amount corresponding to a unit length of the filling material 2032.

It is assumed that a length of the filling material 2032 is L, and a cross-sectional area is S. When the filling material 2032 extends by $\Delta L$ under an action of a force F, stress $\sigma$ of the filling material 2032 satisfies $\sigma = F/S$, and strain $\varepsilon$ of the filling material 2032 satisfies $\varepsilon = \Delta L/L$.

A larger Young's modulus indicates that deformation of the filling material 2032 is smaller when the filling material 2032 is compressed or stretched.

In this embodiment of this application, if the Young's modulus of the filling material 2032 is less than a Young's modulus of the support member 20, it indicates that the deformation of the filling material 2032 is greater than deformation of the support member 20 when the filling material 2032 is compressed or stretched. The filling material 2032 is disposed in the through hole of the support member 20, so that deformation is more likely to occur at a location of the through hole of the support member 20. This helps improve bending performance of the support member 20.

In addition, the filling material is disposed in the through hole of the support member 20, to help improve anti-extrusion performance and anti-impact performance of the support member 20.

In some embodiments of this application, for example, a glass transition temperature (glass transition temperature, Tg) of the filling material 2032 is less than 0°C. In some other embodiments of this application, the glass transition temperature of the filling material 2032 is, for example, less than -10°C. The glass transition temperature means a temperature corresponding to a change of the filling material 2032 from a glass state to a high elastic state.

It should be noted that, for a same system of polymer materials, a lower Tg indicates a lower elastic modulus at a normal temperature, and a reliability gain is correspondingly reduced.

An ambient temperature of the electronic device is usually greater than or equal to the glass transition temperature of the filling material 2032. In other words, in a normal use state, the filling material 2032 is in the high elastic state, so that the deformation is more likely to occur at the location of the through hole of the support member 20. This helps improve the bending performance of the support member 20.

Stress relaxation recovery of the filling material 2032 is, for example, greater than 90%. The stress relaxation recovery means that stress of the filling material 2032 is reduced under a constant temperature and longterm constant strain, and unrecoverable plastic deformation is generated.

An elastic limit of the filling material 2032 is, for example, greater than 50%. The elastic limit is a limit value of the deformation of the filling material 2032 under an external force. If the deformation of the filling material 2032 under the external force is less than the limit value, when the external force stops, the deformation of the filling material 2032 may totally disappear and the filling material 2032 is restored to an original state. If the deformation of the filling material 2032 under the external force exceeds the limit value, the filling material 2032 cannot be totally restored to an original state even if the external force is removed.

It should be noted that, the filling material 2032 provided in this embodiment of this application should meet at least one of the following conditions: the Young's modulus is greater than 1 Mpa, the glass transition temperature is less than 0°C, a stress relaxation recovery rate is greater than 90%, and the elastic limit is greater than 50%.

A material of the support member is not limited in this embodiment of this application. In some embodiments of this application, the material of the support member includes at least one of a fiber, a pure metal, and an alloy, for example, a carbon fiber, stainless steel, an aluminum alloy, or a titanium alloy.

A material of the filling material 2032 is not limited in this embodiment of this application. In some embodiments of this application, the filling material 2032 includes at least one of a filling adhesive, resin, and a polymer material.

The filling adhesive includes at least one of a photosensitive adhesive, a thermosetting adhesive, and a moisture-curing adhesive, and in some embodiments, may alternatively be a mixed adhesive of two or more of them.

The photosensitive adhesive may be, for example, an ultraviolet (Ultraviolet Light, UV) curing adhesive or an optical clear adhesive (Optical Clear Adhesive, OCA). Both the UV adhesive and the OCA adhesive have specific light curing performance, and the UV adhesive and the OCA adhesive are cured under light irradiation.

The thermosetting adhesive may be cured, for example, through heating.

For example, the moisture-curing adhesive may react with components such as water vapor and oxygen in air to complete curing.

A thickness of the filling material 2032 is not limited in this embodiment of this application, and the thickness of the filling material 2032 is less than or equal to a thickness of the support member. For example, the thickness of the support member is 50 μm to 300 μm.

A molding manner of the filling material 2032 is not limited in this embodiment of this application. In some embodiments of this application, the filling material 2032 is filled into the through hole in an inkjet printing manner.

An embodiment of this application further provides a method for manufacturing a support member. The support member is configured to support a display. As shown in FIG. 5, the method for manufacturing the support member includes the following steps.

S101: Fill a filling material into a through hole of a bendable support member in an inkjet printing manner.

The display includes a first unbendable portion, a second unbendable portion, and a bendable portion.

The support member includes a first support member opposite to the first unbendable portion, a second support member opposite to the second unbendable portion, and a bendable support member opposite to the bendable portion. The bendable support member is located between the first support member and the second support member.

The bendable support member includes a first surface opposite to the bendable portion and a second surface opposite to the first surface. One or more through holes are provided on the bendable support member. The through hole penetrates through the first surface and the second surface of the bendable support member.

The filling material is printer ink. For example, an ultraviolet (Ultraviolet Light, UV) curing adhesive may be used, and a Young's modulus obtained by curing the UV curing adhesive is less than a Young's modulus of the support member.

Compared with conventional coating technologies such as spraying coating, scrape coating, and screen printing, a filling manner of the inkjet printing can implement patterned coating, and has advantages of high printing precision and good uniformity of a printed filling material.

An inkjet printing apparatus usually includes an ink cartridge and a nozzle capable of accurately depositing a solution in a design area. The nozzle may accurately spray the filling material (the printer ink) into the through hole of the support member.

A spraying characteristic, solution volatilization behavior, ink viscosity and a nozzle diameter of the printer ink are important parameters that affect a resolution. In some embodiments of this application, the ink viscosity, surface tension, and density need to meet a black printing window shown in FIG. 6, to implement adhesive spraying.

Adhesive characteristics at the black printing window shown in FIG. 6 need to meet the following requirements: an adhesive Reynolds number Re: $100 \leq Re \leq 1000$, and an adhesive Ohnesorge number Oh: $0.1 \leq Oh \leq 1$.

When the adhesive Reynolds number Re is less than 100, a viscosity force affects the ink more than an inertia force, and an ink flow speed is attenuated by the viscosity force. As a result, ink fluidity is deteriorated, affecting spraying of the nozzle.

When the adhesive Reynolds number Re is greater than 1000, a satellite point is generated. Because the ink viscosity is too low, the ink is leaked out of the nozzle and forms the satellite point under high frequency spraying.

Adhesive Reynolds number $Re = \dfrac{\rho vd}{\mu} = \text{Inertia force/Viscosity force}$ ρ is the ink density, μ is the ink viscosity, d is the nozzle diameter, and v is a nozzle inkjet speed.

When the adhesive Ohnesorge number Oh is less than 0.1, the ink viscosity is too low, and the ink is leaked out of the nozzle, and forms a satellite point under high frequency spraying.

When the adhesive Ohnesorge number Oh is greater than 1, the ink viscosity is too high, and fluidity is deteriorated, affecting spraying of the nozzle.

Adhesive Ohnesorge number $Oh = \dfrac{\mu}{\sqrt{\rho \sigma d}} = \text{Viscosity force}/\sqrt{\text{Inertia force} \times \text{Surface tension}}$

S102: Cure the filling material.

A height of the filling material is less than or equal to a height of the through hole, and a Young's modulus of a cured filling material is less than the Young's modulus of the support member.

It should be noted that, to prevent the filling material from flowing out of the through hole, before step S101, a bearing layer further needs to be attached to one surface of the bendable support member.

Step S101 includes: performing the inkjet printing on a surface that is of the bendable support member and that is away from the bearing layer, and filling the filling material into the through hole of the bendable support member.

A structure of the bearing layer is not limited in this embodiment of this application.

In some embodiments of this application, the bearing layer uses a release film.

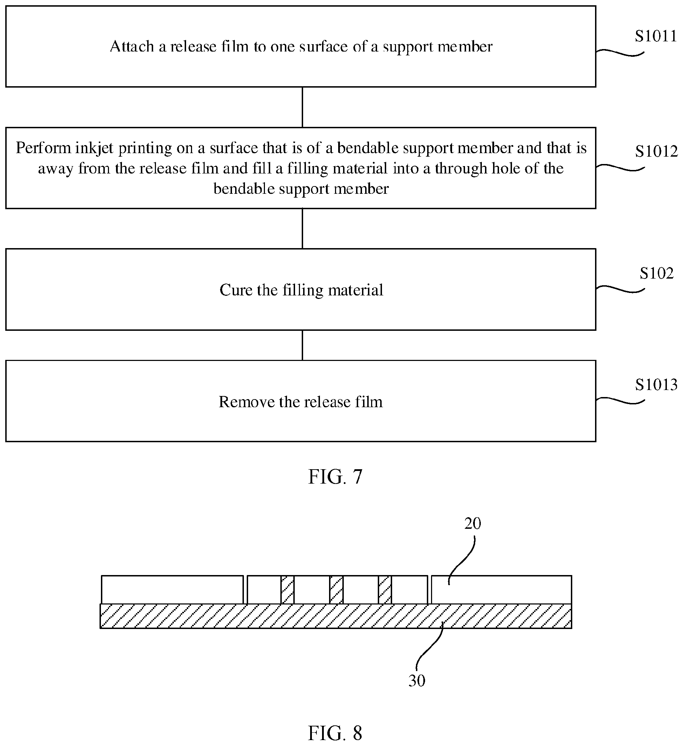

As shown in FIG. 7, filling the filling material into the through hole of the bendable support member in the inkjet printing manner includes the following steps.

S1011: As shown in FIG. 8, attach a release film 30 to one surface of a support member 20.

The release film 30 includes a first surface and a second surface that are opposite to each other. For example, an adhesive layer is disposed on the first surface of the release film 30, and the release film 30 may be bonded to the surface of the support member 20 through the adhesive layer.

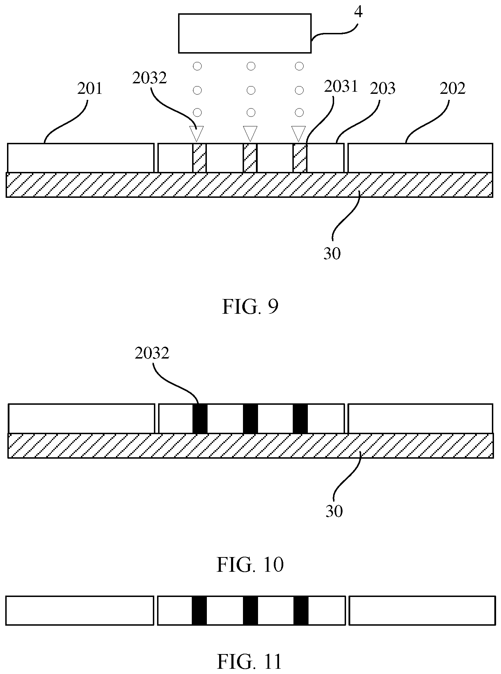

S1012: As shown in FIG. 9, perform the inkjet printing on the surface that is of a bendable support member 203 and that is away from the release film. As shown in FIG. 10, fill a filling material 2032 into a through hole 2031 of the bendable support member 203.

The support member includes a first support member 201, a second support member 202, and a bendable support member 203 located between the first support member 201 and the second support member 202. The filling material 2032 is filled into the through hole 2031 of the bendable support member 203.

An inkjet printing technology (Inkjet printing) is a non-contact micron-level printing process, and the printer ink (the filling material in this application) may be accurately sprayed to the through hole 2031 of the bendable support member 203 by using an inkjet printer 4.

In addition, refer to FIG. 7 again. After step S102, the method further includes the following steps.

S1013: As shown in FIG. 11, remove the release film 30 shown in FIG. 10.

In some other embodiments of this application, the bearing layer may be a display.

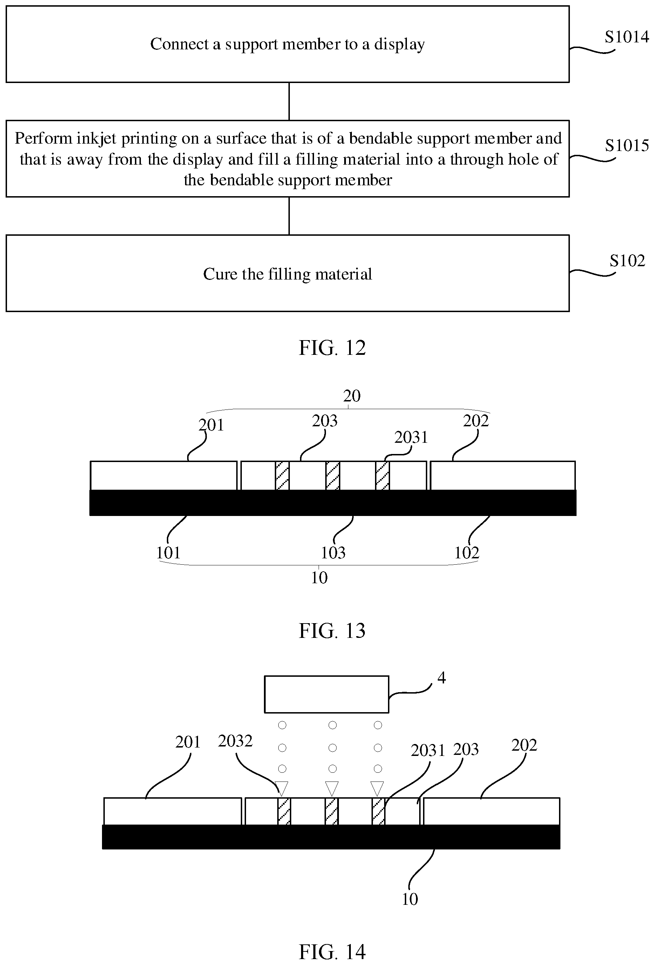

As shown in FIG. 12, filling the filling material into the through hole of the support member in the inkjet printing manner includes the following steps.

S1014: As shown in FIG. 13, connect a support member 20 to a display 10.

The display 10 is, for example, a flexible display. The display 10 includes a display surface and a non-display surface. The support member 20 is disposed close to the non-display surface of the display 10. The support member 20 may be bonded to the display 10 through the adhesive layer.

The support member includes a first support member 201, a second support member 202, and a bendable support member 203 located between the first support member 201 and the second support member 202. The first support member 201 is configured to support a first unbendable portion 101 of the display 10. The second support member 202 is configured to support a second unbendable portion 102 of the display. The bendable support member 203 is configured to support a bendable portion 103 of the display.

S1015: As shown in FIG. 14, perform the inkjet printing on a surface that is of the bendable support member 203 and that is away from the display 10, and fill a filling material 2032 into a through hole 2031 of the bendable support member 203.

The filling material 2032 is filled into the through hole 2031 of the bendable support member 203.

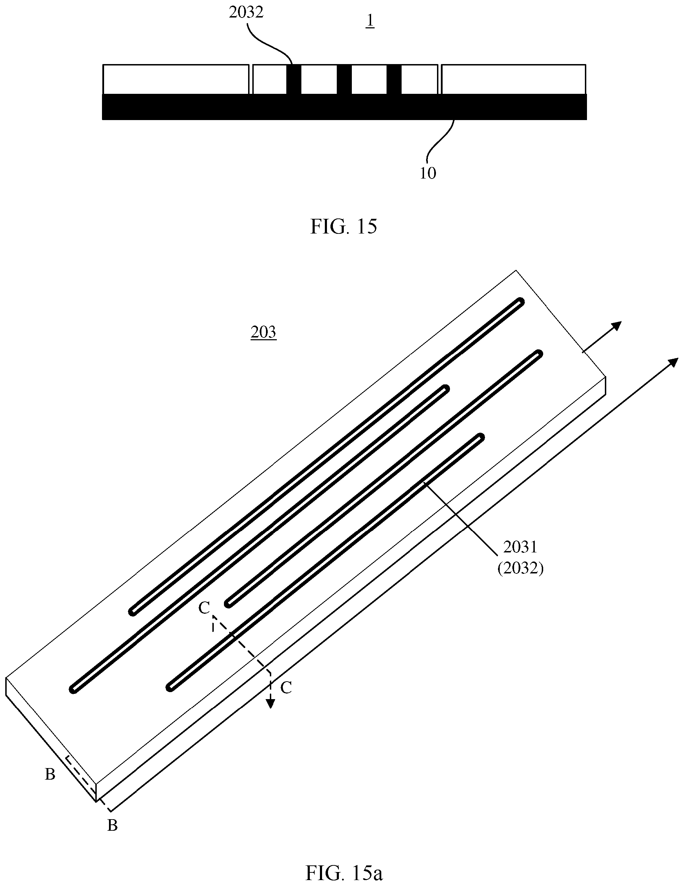

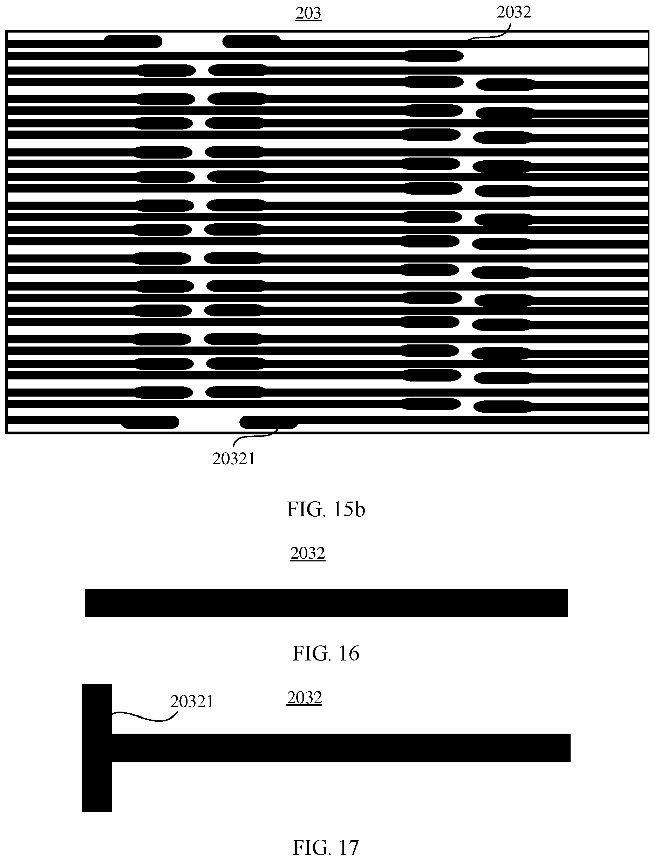

The printer ink (the filling material 2032 in this application) may be accurately sprayed to the through hole 2031 of the bendable support member 203 by using an inkjet printer 4, to obtain a display module 1 shown in FIG. 15.

Therefore, compared with conventional coating technologies such as spraying coating, scrape coating, and screen printing, filling the filling material into the through hole of the support member in the inkjet printing manner can implement patterned coating, and has advantages of high printing precision and good uniformity of the printed filling material.

An impact test is performed on an electronic device provided in this embodiment of this application, and a test result is shown in Table 1.

**Table 1**

| Filling material 2032 | Support member material | Impact reliability (unit: mm) | Impact reliability improvement gain |
|---|---|---|---|
| None | Titanium alloy | 65 | |
| Filling material 1 | Titanium alloy | 90 | 38% |
| Filling material 2 | Titanium alloy | 105 | 61% |
| None | Carbon fiber | 60 | |
| Filling material 1 | Carbon fiber | 77.5 | 29% |
| Filling material 2 | Carbon fiber | 81.25 | 36% |

The filling material 1 and the filling material 2 are filling adhesives of an acrylic acid system. The filling material 1 and the filling material 2 are different in materials and have different anti-impact performance.

It should be noted that, impact reliability of the electronic device may be represented by a critical failure height of the electronic device. The critical failure height of the electronic device may be obtained by performing a sharp-head impact test on the electronic device by using an impact tester. The critical failure height of the electronic device means a falling height of a sharp head. When the falling height is exceeded, the electronic device is impacted and a broken bright spot is generated.

It can be learned from Table 1 that, compared with the carbon fiber material, a support member made of the titanium alloy material has better anti-impact performance.

When the support member is made of the titanium alloy material, compared with a case in which no filling material is disposed in a through hole of the support member, after the filling material 1 is disposed in the through hole of the support member, the impact reliability of the electronic device is increased by 38%.

When the support member is made of the titanium alloy material, compared with a case in which no filling material is disposed in a through hole of the support member, after the filling material 2 is disposed in the through hole of the support member, the impact reliability of the electronic device is increased by 61%.

When the support member is made of the carbon fiber material, compared with a case in which no filling material is disposed in a through hole of the support member, after the filling material 1 is disposed in the through hole of the support member, the impact reliability of the electronic device is increased by 29%.

When the support member is made of the carbon fiber material, compared with a case in which no filling material is disposed in a through hole of the support member, after the filling material 2 is disposed in the through hole of the support member, the impact reliability of the electronic device is increased by 36%.

In conclusion, after the filling material is disposed in the through hole of the support member of the electronic device, anti-impact performance of the electronic device can be increased by more than 30%.

Therefore, the filling material is disposed in the through hole of the support member, to improve anti-impact performance and anti-extrusion performance of the electronic device. A Young's modulus of the filling material is less than a Young's modulus of the support member. When the filling material is compressed or stretched, deformation of the filling material is greater than deformation of the support member. The filling material is disposed in the through hole of the support member, to help further improve bending performance of a bendable region of the support member.

A shape of the filling material 2032 is not limited in this embodiment of this application. In some embodiments of this application, FIG. 15a is a diagram of a structure of a bendable support member according to an embodiment of this application. FIG. 15b is a top view of the bendable support member in FIG. 15a. As shown in FIG. 15a and FIG. 15b, the filling material 2032 is of a strip shape structure, and a length direction of the filling material 2032 is parallel to a length direction of a bendable portion.

For example, a cross section shape of the filling material 2032 includes a straight line shape shown in FIG. 16.

In some embodiments, as shown in FIG. 15b, the filling material further includes a first limiting portion 20321. The first limiting portion 20321 is disposed on at least one end of the filling material in a length direction. A longitudinal section size of the first limiting portion 20321 is greater than a longitudinal section size of the filling material. The first limiting portion is snap-fitted to the through hole. In this way, the first limiting portion 20321 may change stress distribution on the support member.

For example, as shown in FIG. 17, the filling material 2032 includes one first limiting portion 20321, and a cross section shape of the filling material 2032 includes a T shape.

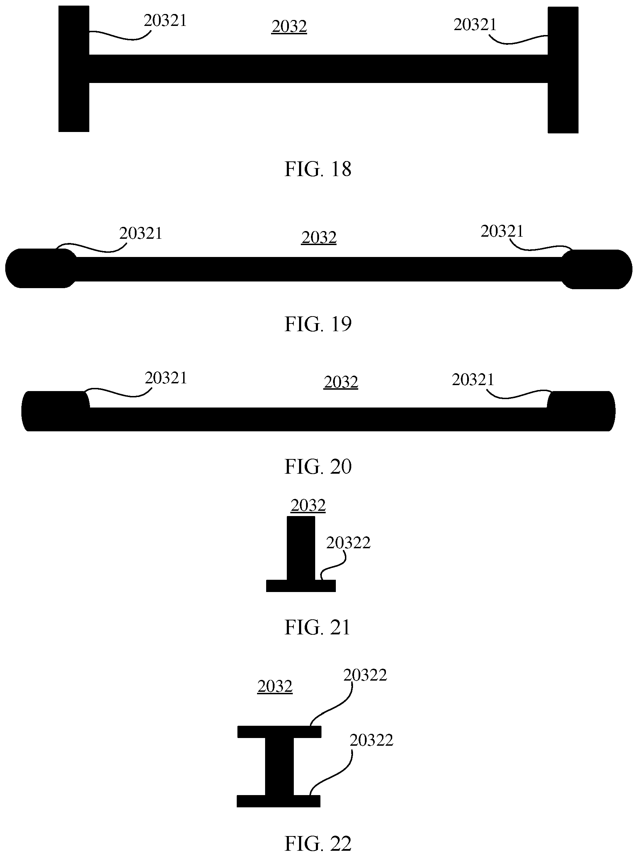

As shown in FIG. 18, FIG. 19, and FIG. 20, the filling material 2032 includes two first limiting portions 20321, and a cross section shape of the filling material 2032 includes an I-shaped shape shown in FIG. 18, and an hourglass shape shown in FIG. 19 and FIG. 20.

In some other embodiments, the filling material 2032 further includes a second limiting portion 20322. The second limiting portion 20322 is disposed on at least one end of the filling material 2032 in a thickness direction. A cross section size of the second limiting portion 20322 is greater than a cross section size of the filling material 2032. The second limiting portion is snap-fitted to the through hole.

In this way, the second limiting portion 20322 may prevent the filling material 2032 from being extruded out during use.

For example, as shown in FIG. 21, the filling material 2032 includes one second limiting portion 20322, and a longitudinal section shape of the filling material 2032 includes a T shape.

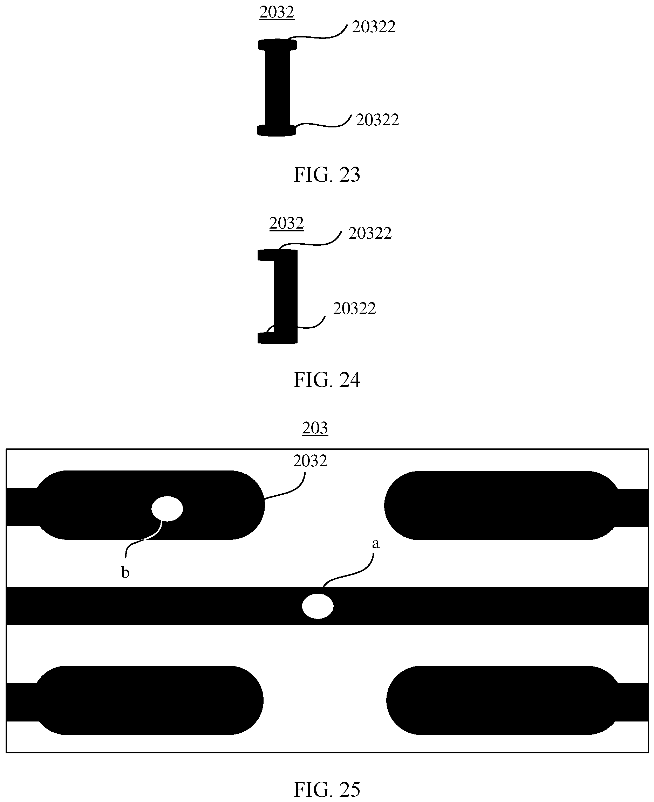

As shown in FIG. 22, FIG. 23, and FIG. 24, the filling material 2032 includes two second limiting portions 20322, and a longitudinal section shape of the filling material 2032 includes an I-shaped shape shown in FIG. 22 and an hourglass shape shown in FIG. 23 and FIG. 24.

As shown in FIG. 25, the through hole is filled with the filling material 2032, and different locations of the filling material 2032 have different anti-impact capabilities. A location a is located in the first limiting portion 20321 of the filling material 2032, and a location b is located in the middle of the filling material 2032. The impact test is performed on different locations of the electronic device. Impact test results of regions corresponding to the location a and the location b in FIG. 25 in the electronic device are shown in Table 2.

**Table 2**

| Whether a filling material is disposed in a through hole | Critical failure height for sharp head impact of an electronic device at a location a | Critical failure height for sharp head impact of an electronic device at a location b |
|---|---|---|
| No filling material | 108 | 74.1 |
| Have a filling material | 119 | 101 |

It can be learned from Table 2 that, at the location a, when there is no filling material in the through hole of the support member, the critical failure height of the electronic device is 108 mm, and when there is the filling material in the through hole of the support member, the critical failure height of the electronic device is increased to 119 mm.

At the location b, when there is no filling material in the through hole of the support member, the critical failure height of the electronic device is 74.1 mm; and when there is the filling material in the through hole of the support member, the critical failure height of the electronic device is increased to 101 mm.

Therefore, the filling material is disposed in the through hole of the support member of the electronic device, so that anti-impact performance of a location corresponding to the through hole and the electronic device can be improved.

In addition, refer to Table 2 again. Compared with the critical failure height of the region corresponding to the location b and the electronic device, the critical failure height of the region corresponding to the location a and the electronic device is higher.

Therefore, compared with a region corresponding to two ends (the first limiting portion 20321) of the through hole of the support member and the electronic device, a region corresponding to a middle location of the support member and the electronic device have better anti-impact performance.

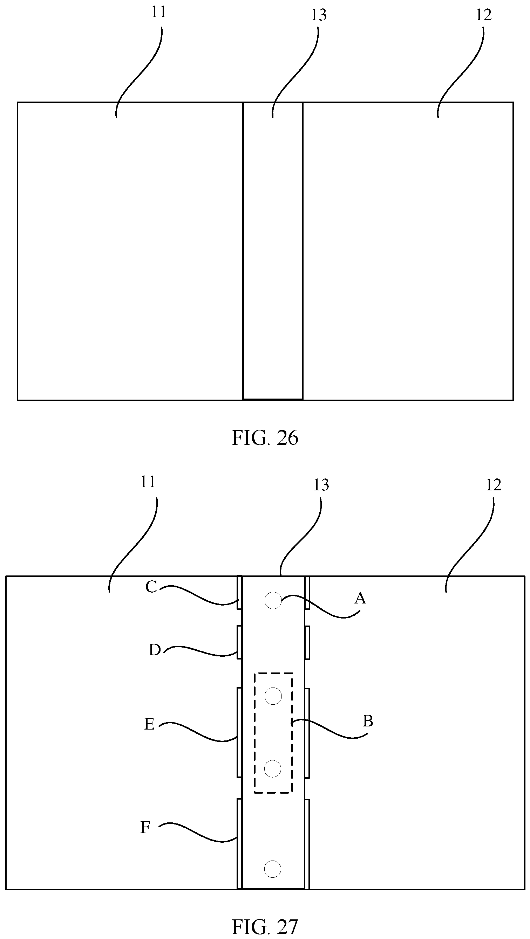

FIG. 26 is a top view of an electronic device according to an embodiment of this application. As shown in FIG. 26, the electronic device includes a first plane display area 11, a second plane display area 12, and a rotating shaft region 13.

The impact test is performed on a rotating shaft region 13 of the electronic device provided in this embodiment of this application, and a test result is shown in Table 3.

**Table 3**

| Sample number | Sharp head impact of a rotating shaft region (mm) | | |
|---|---|---|---|
| | Failure height (mm) | Impact improvement | Gain (%) |
| No filling material | 65 | - | - |
| Have a filling material | 105 | 40 | 61% |

Table 3 is an average value of test results of the impact test performed on six groups of electronic devices with no filling material in through holes of support members respectively, and an average value of test results of the impact test performed on six groups of electronic devices with the filling material in the through holes of the support members.

It can be learned from Table 3 that, compared with a case in which no filling material is disposed in the through hole of the support member, after the filling material is disposed in the through hole of the support member, and the rotating shaft region 13 of the electronic device is impacted by the sharp head, the critical failure height is increased by 40 mm, and the critical failure height gain is increased by 61%.

FIG. 27 is a diagram of an internal structure of an electronic device according to an embodiment of this application. As shown in FIG. 27, a weak region of the rotating shaft region 13 of the electronic device includes: a location A, a location B, a location C, a location D, a location E, and a location F, where small holes are disposed on a rotating shaft corresponding to the location A and the location B, and the location C, the location D, the location E, and the location F are gap locations between the rotating shaft and the first plane display area 11.

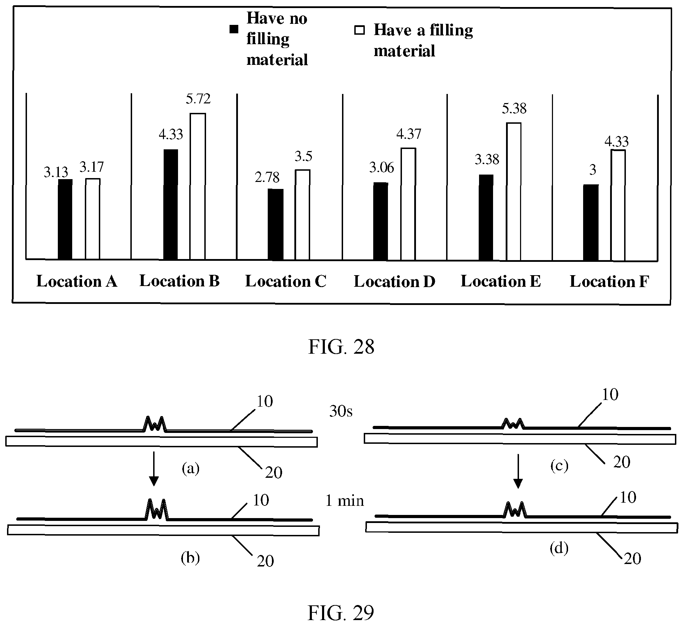

FIG. 28 is a diagram of an impact test result at a weak location in a rotating shaft region of an electronic device. As shown in FIG. 28, compared with the case in which no filling material is disposed in the through hole of the support member, after the filling material 2032 is disposed in a through hole 2031, in the rotating shaft region 13, in addition to the location A remaining the same, anti-impact performance of the location B is increased by 32%, anti-impact performance of the location C is increased by 26%, anti-impact performance of the location D is increased by 43%, anti-impact performance of the location E is increased by 59%, and anti-impact performance of the location F is increased by 44%.

The filling material is disposed in the through hole of the support member of the electronic device, so that anti-impact performance of a location corresponding to the rotating shaft weak region of the electronic device can be improved.

FIG. 29 is a diagram of an extrusion test result of an electronic device according to an embodiment of this application. As shown in (a) and (b) in FIG. 29, when no filling material is disposed in the through hole of the support member, an extrusion test is performed on a folded display for thirty seconds (s) to 1 minute (min), and a crease is deep. As shown in (c) and (d) in FIG. 29, after the filling material is disposed in the through hole of the support member, the extrusion test is performed on the folded display for thirty seconds (s) to 1 minute (min), and a crease is shallow.

Therefore, the filling material is disposed in the through hole of the support member of the electronic device, so that the anti-extrusion performance of the electronic device can be improved.

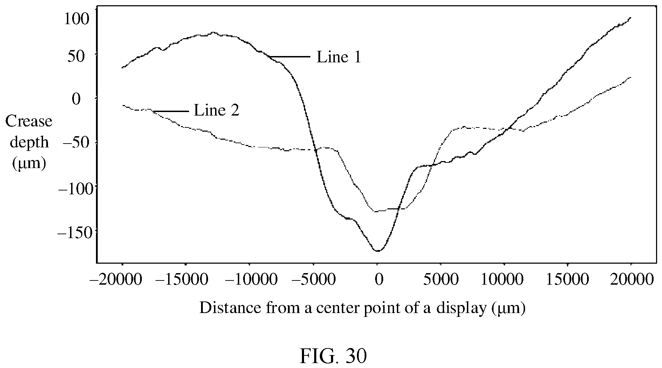

FIG. 30 is a simulation diagram of an extrusion test result of an electronic device according to an embodiment of this application. A horizontal coordinate indicates a length between locations of a bendable end of the display and a center point location, and a unit is $\mu$m. A vertical coordinate indicates a crease depth, and a unit is $\mu$m. It should be noted that when the horizontal coordinate is 0, a location is a center location of the bendable end of the display, and when the vertical coordinate is 0, it indicates that a location of the display is not bent.

A line 1 is a bending curve of the display when there is no filling material in the through hole of the support member. A line 2 is a bending curve of the display when there is the filling material in the through hole of the support member.

As shown in FIG. 30, compared with the case in which no filling material is disposed in the through hole of the support member, after the filling material is disposed in the through hole of the support member, an extrusion test is performed on the folded display, and a crease of the folded display is reduced from 201.17 micrometers to 96.92 micrometers.

In this way, the filling material is added to the through hole of the support member, so that the crease depth of the display can be shallower.

The Young's modulus of the filling material also affects the anti-extrusion performance of the electronic device. Further, an entire-device crease test is performed on the electronic device provided in this embodiment of this application, and a test result is shown in Table 4.

**Table 4**

| Whether there is a filling material | Crease depth/$\mu$m |
| --- | --- |
| No filling material | 60.3 |
| Young's modulus of the filling material is increased to 2 times | 44.8 |
| Young's modulus of the filling material is increased to 4 times | 33.9 |

It can be learned from Table 4 that, compared with that no filling material is disposed in the through hole of the support member, after the filling material is disposed in the through hole of the support member, the crease depth becomes shallower, and as the Young's modulus of the filling material 2032 increases, the crease is obviously improved.

Embodiments of this application provide the support member, the method for manufacturing the support member, the display module, and the electronic device. The filling material is disposed in the through hole in the bendable region of the support member, to improve the anti-impact performance and the anti-extrusion performance of the electronic device. An elastic modulus of the filling material is less than an elastic modulus of the support member. When the filling material is compressed or stretched, the deformation of the filling material is greater than the deformation of the support member. The filling material is disposed in the through hole of the support member, to help further improve the bending performance of the bendable region of the support member.

The foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

**Claims**

1. A support member, wherein the support member is configured to support a display, and the display comprises a first unbendable portion, a second unbendable portion, and a bendable portion;

   the support member comprises a first support member opposite to the first unbendable portion, a second support member opposite to the second unbendable portion, and a bendable support member opposite to the bendable portion, and the bendable support member is located between the first support member and the second support member;
   the bendable support member comprises a first surface opposite to the bendable portion and a second surface opposite to the first surface, one or more through holes are provided on the bendable support member, and the through hole penetrates through the first surface and the second surface of the bendable support member; and the through hole is filled with a filling material, a thickness of the filling material is less than or equal to a thickness of the support member, and an elastic modulus of the filling material is less than an elastic modulus of the support member.

2. The support member according to claim 1, wherein the filling material is filled into the through hole in an inkjet printing manner.

3. The support member according to claim 1 or 2, wherein the filling material comprises at least one of a filling adhesive, resin, and a polymer material.

4. The support member according to any one of claims 1 to 3, wherein the filling adhesive comprises at least one of a photosensitive adhesive, a thermosetting adhesive, and a moisture-curing adhesive.

5. The support member according to claim 4, wherein the filling material is in a strip shape, and a length direction of the filling material is parallel to a length direction of the bendable portion.

6. The support member according to any one of claims 1 to 5, wherein the filling material further comprises a first limiting portion, the first limiting portion is disposed on at least one end of the filling material in the length direction, and the first limiting portion is snap-fitted to the through hole.

7. The support member according to any one of claims 1 to 6, wherein the filling material further comprises a second limiting portion, the second limiting portion is disposed on at least one end of the filling material in a thickness direction, and the second limiting portion is snap-fitted to the through hole.

8. The support member according to any one of claims 1 to 7, wherein the filling material meets at least one of the following conditions:

   a Young's modulus is greater than 1 MPa;
   a glass transition temperature is less than 0°C;
   a stress relaxation recovery rate is greater than 90%; and
   an elastic limit is greater than 50%.

9. The support member according to any one of claims 1 to 8, wherein a material of the support member comprises at least one of a fiber, a pure metal, and an alloy.

10. A method for manufacturing a support member, wherein the support member is configured to support a display, and the display comprises a first unbendable portion, a second unbendable portion, and a bendable portion; and
    the support member comprises a first support member opposite to the first unbendable portion, a second support member opposite to the second unbendable portion, and a bendable support member opposite to the bendable portion, and the bendable support member is located between the first support member and the second support member; and the method comprises:

    filling a filling material into a through hole of the bendable support member in an inkjet printing manner, wherein the bendable support member comprises a first surface opposite to the bendable portion and a second surface opposite to the first surface, one or more through holes are provided on the bendable support member, and the through hole penetrates through the first surface and the second surface of the bendable support member; and curing the filling material, wherein a height of the filling material is less than or equal to a height of the through hole, and an elastic modulus of the filling material is less than an elastic modulus of the support member.

11. The method for manufacturing the support member according to claim 10, wherein the filling a filling material into a through hole of the bendable support member in an inkjet printing manner comprises:

    attaching a bearing layer to one surface of the bendable support member; and
    performing inkjet printing on a surface that is of the bendable support member and that is away from the bearing layer, and filling the filling material into the through hole of the bendable support member.

12. The method for manufacturing the support member according to claim 11, wherein after the curing the filling material, the method further comprises:
removing the bearing layer.

13. A display module, comprising a display and the support member according to any one of claims 1 to 9, wherein the display comprises a display panel and a cover plate that are disposed in a stacked manner, a backlight surface of the display panel is close to the support member, and the cover plate is disposed on a light-emitting surface of the display panel.

14. The display module according to claim 13, wherein a protective film is disposed on a side that is of the cover plate and that is away from the display panel.

15. An electronic device, comprising a housing and the display module according to claim 13 or 14, wherein the housing is disposed on a side that is of the support member and that is away from the display.

FIG. 1a

FIG. 1b

FIG. 2

FIG. 3

FIG. 4

Fill a filling material into a through hole of a bendable support member in an inkjet printing manner — S101

Cure the filling material — S102

FIG. 5

Ohnesorge number Oh

Reynolds number Re

FIG. 6

| Attach a release film to one surface of a support member | S1011 |

| Perform inkjet printing on a surface that is of a bendable support member and that is away from the release film and fill a filling material into a through hole of the bendable support member | S1012 |

| Cure the filling material | S102 |

| Remove the release film | S1013 |

FIG. 7

20

30

FIG. 8

FIG. 9

FIG. 10

FIG. 11

| | |
|---|---|
| Connect a support member to a display | S1014 |

| | |
|---|---|
| Perform inkjet printing on a surface that is of a bendable support member and that is away from the display and fill a filling material into a through hole of the bendable support member | S1015 |

| | |
|---|---|
| Cure the filling material | S102 |

FIG. 12

FIG. 13

FIG. 14

2032

1

10

FIG. 15

203

2031
(2032)

C

C

B

B

FIG. 15a

FIG. 15b

FIG. 16

FIG. 17

20321     2032     20321

FIG. 18

20321     2032     20321

FIG. 19

20321     2032     20321

FIG. 20

2032
20322

FIG. 21

2032     20322

20322

FIG. 22

2032

20322

20322

FIG. 23

2032

20322

20322

FIG. 24

203

2032

b

a

FIG. 25

11    13    12

**FIG. 26**

11    13    12

C    A

D

E    B

F

**FIG. 27**

FIG. 28

FIG. 29

FIG. 30

## INTERNATIONAL SEARCH REPORT

| | |
|---|---|
| International application No. | |
| | **PCT/CN2023/101342** |

**A.    CLASSIFICATION OF SUBJECT MATTER**

G09F9/30(2006.01)i; H04M1/02(2006.01)i

According to International Patent Classification (IPC) or to both national classification and IPC

**B.    FIELDS SEARCHED**

Minimum documentation searched (classification system followed by classification symbols)

IPC:G09F H04M G02F

Documentation searched other than minimum documentation to the extent that such documents are included in the fields searched

Electronic data base consulted during the international search (name of data base and, where practicable, search terms used)

CNABS; CNTXT; CNKI; VEN; USTXT; EPTXT; WOTXT: 华为, 荣耀, 支撑, 弯折, 弯曲, 折弯, 折叠, 显示, 屏, 孔, 开口, 缝, 槽, 填充, 弹性模型, 杨氏模量, 模量, 硬度, 刚度, 剪切模量, 体积模量, 柔性, 限位, 胶, 接触面积, groove?, flute?, notch??, recess??, hole?, aperture?, slit?, slot?, gap, elastic+ modulus, Young's modulus, modulus, rigidity, stiffness, bend+, bent, flex+, fold+, fill+

**C.    DOCUMENTS CONSIDERED TO BE RELEVANT**

| Category* | Citation of document, with indication, where appropriate, of the relevant passages | Relevant to claim No. |
|---|---|---|
| PX | CN 115171528 A (HUAWEI TECHNOLOGIES CO., LTD.) 11 October 2022 (2022-10-11) description, paragraphs [0057]-[0195], and figures 1a-30 | 1-15 |
| PX | CN 115620616 A (HONOR TERMINAL CO., LTD.) 17 January 2023 (2023-01-17) description, paragraphs [0030]-[0044], and figures 1-3 | 1-5, 9-15 |
| X | CN 111510527 A (GUANGDONG OPPO MOBILE TELECOMMUNICATIONS CORP., LTD.) 07 August 2020 (2020-08-07) description, paragraphs [0027]-[0076], and figures 1-11 | 1-5, 9-15 |
| X | CN 111312660 A (BOE TECHNOLOGY GROUP CO., LTD.) 19 June 2020 (2020-06-19) description, paragraphs [0026]-[0044], and figures 1-3 | 1-5, 9-15 |
| X | CN 113257124 A (HONOR TERMINAL CO., LTD.) 13 August 2021 (2021-08-13) description, paragraphs [0041]-[0075], and figures 1-13 | 1-5, 9-15 |
| X | CN 210955911 U (EVERDISPLAY OPTRONICS (SHANGHAI) CO., LTD.) 07 July 2020 (2020-07-07) description, paragraphs [0036]-[0059], and figures 1-9 | 1-5, 8-15 |

☑ Further documents are listed in the continuation of Box C.          ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **10 July 2023** | **07 August 2023** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

| International application No. |
| --- |
| **PCT/CN2023/101342** |

**C. DOCUMENTS CONSIDERED TO BE RELEVANT**

| Category* | Citation of document, with indication, where appropriate, of the relevant passages | Relevant to claim No. |
| --- | --- | --- |
| Y | CN 210955911 U (EVERDISPLAY OPTRONICS (SHANGHAI) CO., LTD.) 07 July 2020 (2020-07-07) <br> description, paragraphs [0036]-[0059], and figures 1-9 | 6-9, 13-15 |
| Y | CN 113129746 A (WUHAN CHINA STAR OPTOELECTRONICS TECHNOLOGY CO., LTD. et al.) 16 July 2021 (2021-07-16) <br> description, paragraphs [0051]-[0068], and figure 4 | 6-9, 13-15 |
| A | US 2022050321 A1 (LG INNOTEK CO., LTD.) 17 February 2022 (2022-02-17) <br> entire document | 1-15 |

Form PCT/ISA/210 (second sheet) (July 2022)

**INTERNATIONAL SEARCH REPORT**
**Information on patent family members**

International application No.

**PCT/CN2023/101342**

| Patent document cited in search report | | | Publication date (day/month/year) | Patent family member(s) | | | Publication date (day/month/year) |
|---|---|---|---|---|---|---|---|
| CN | 115171528 | A | 11 October 2022 | None | | | |
| CN | 115620616 | A | 17 January 2023 | None | | | |
| CN | 111510527 | A | 07 August 2020 | None | | | |
| CN | 111312660 | A | 19 June 2020 | US | 2021265590 | A1 | 26 August 2021 |
| | | | | US | 11581506 | B2 | 14 February 2023 |
| CN | 113257124 | A | 13 August 2021 | None | | | |
| CN | 210955911 | U | 07 July 2020 | None | | | |
| CN | 113129746 | A | 16 July 2021 | None | | | |
| US | 2022050321 | A1 | 17 February 2022 | WO | 2020060134 | A1 | 26 March 2020 |
| | | | | KR | 20200034333 | A | 31 March 2020 |
| | | | | TW | 202018385 | A | 16 May 2020 |

Form PCT/ISA/210 (patent family annex) (July 2022)

REFERENCES CITED IN THE DESCRIPTION

**Patent documents cited in the description**

- CN 202210711705